Europäisches Patentamt

European Patent Office

Office européen des brevets

(11) Veröffentlichungsnummer: **0 387 917**
**A2**

(12) # EUROPÄISCHE PATENTANMELDUNG

(21) Anmeldenummer: 90105744.8

(22) Anmeldetag: **13.03.90**

(51) Int. Cl.5: **H01L 29/784, H01L 29/10**

(30) Priorität: **15.03.89 DE 3908465**

(43) Veröffentlichungstag der Anmeldung:
**19.09.90 Patentblatt 90/38**

(84) Benannte Vertragsstaaten:
**DE FR GB IT**

(71) Anmelder: **Siemens Aktiengesellschaft**
**Wittelsbacherplatz 2**
**D-8000 München 2(DE)**

(72) Erfinder: **Bergmann, Rainer, Dipl.-Ing.**
**Ahornstrasse 24**
**D-8069 Rohrbach(DE)**
Erfinder: **Gantioler, Josef, Dipl.-Ing.**
**Bernheimerstrasse 6**
**D-8000 München 81(DE)**
Erfinder: **Heil, Holger, Dipl.-Phys.**
**Amalienstrasse 99**
**D-8000 München 40(DE)**
Erfinder: **Stengl, Jens-Peter**
**Kirchfeldstrasse 6**
**D-8082 Grafrath(DE)**

(54) **Leistungs-MOSFET mit hoher Durchbruchsfestigkeit.**

(57) Die Durchbruchsfestigkeit wird dadurch erhöht, daß der Durchbruchstrom über den stark dotierten Teil (9) der Gatezone direkt in den Sourcekontakt (10) abfließt und nicht lateral unter der Sourcezone (3). Dies erreicht man, indem der starkdotierte Teil (9) mindestens am Boden (20) eines Kontaktlochs (8) angeordnet ist und ein vertikales Profil mit sehr geringem Krümmungsradius (r1) hat.

EP 0 387 917 A2

## Leistungs-MOSFET mit hoher Durchbruchsfestigkeit

Die Erfindung bezieht sich auf einen Leistungs-MOSFET mit einem Halbleiterkörper mit je mindestens einer Drainzone, einer Sourcezone, einer Sourceelektrode, einer Gateelektrode und einer Gatezone, mit den Merkmalen:

Die Gatezone hat einen stark dotierten Teil, der durch ein in der Sourcezone vorgesehenes Kontaktloch mit der Sourceelektrode in Kontakt steht und einen mit dem stark dotierten Teil zusammenhängenden schwach dotierten Teil, der bis unter die Gateelektrode reicht.

Ein Leistungs-MOSFET mit diesen Merkmalen ist bereits in der DE-AI 36 34 982 beschrieben worden. Das dieser Veröffentlichung entnehmbare Ziel besteht darin, die Durchbruchsfestigkeit des Leistungs-MOSFET zu erhöhen. Dazu wird vorgeschlagen, den starkdotierten Teil der Gatezone an der Kante der Gateelektrode enden zu lassen, so daß der schwach dotierte Teil vollständig unter der Gateelektrode liegt. Bricht der pn-Übergang zwischen dem stark dotierten Teil und der Drainzone durch, so kann der lateral unter der Sourcezone fließende Teil des Durchbruchsstroms aufgrund der hohen Dotierung dieses Teils der Gatezone nur einen so geringen Spannungsabfall am zwischen stark dotiertem Teil der Gatezone und der Sourcezone liegenden pn-Übergang hervorrufen, daß noch keine Emission von Ladungsträgern aus der Sourcezone verursacht wird. Damit wird das Einschalten des aus der Sourcezone, dem stark dotiertem Teil der Gatezone und der Drainzone bestehenden parasitären Bipolartransistors verhindert. Der Leistungs-MOSFET wird daher beim Durchbruch nicht zerstört, wenn der Strom kurze Zeit später extern abgeschaltet wird.

Das Ziel der Erfindung besteht darin, die Durchbruchsfestigkeit eines Leistungs-MOSFET mit den oben angegebenen Merkmalen auf andere Weise zu erreichen.

Dieses-Ziel wird dadurch erreicht, daß das Kontaktloch durch den schwach dotierten Teil der Gatezone geht, daß der stark dotierte Teil der Gatezone mindestens am Boden des Kontaktloches in die Drainzone eingebettet ist derart, daß der pn-Übergang zwischen dem stark dotierten Teil der Gatezone und der Drainzone senkrecht zur Oberfläche des Halbleiterkörpers ein Profil mit einem ersten Krümmungsradius zeigt, daß der pn-Übergang zwischen schwach dotiertem Teil und der Drainzone unter der Gateelektrode senkrecht zur genannten Oberfläche ein Profil mit einem zweiten Krümmungsradius zeigt, und daß der erste Krümmungsradius kleiner als der zweite ist.

Die Erfindung wird anhand eines Ausführungsbeispiels in Verbindung mit den FIG 1 bis 4 näher erläutert. Es zeigen

FIG 1 den Schnitt durch einen Leistungs-MOSFET gemäß der Erfindung und

FIG 2 bis 4 je einen Schnitt durch den Halbleiterkörper des Leistungs-MOSFET während charakteristischer Prozeßschritte.

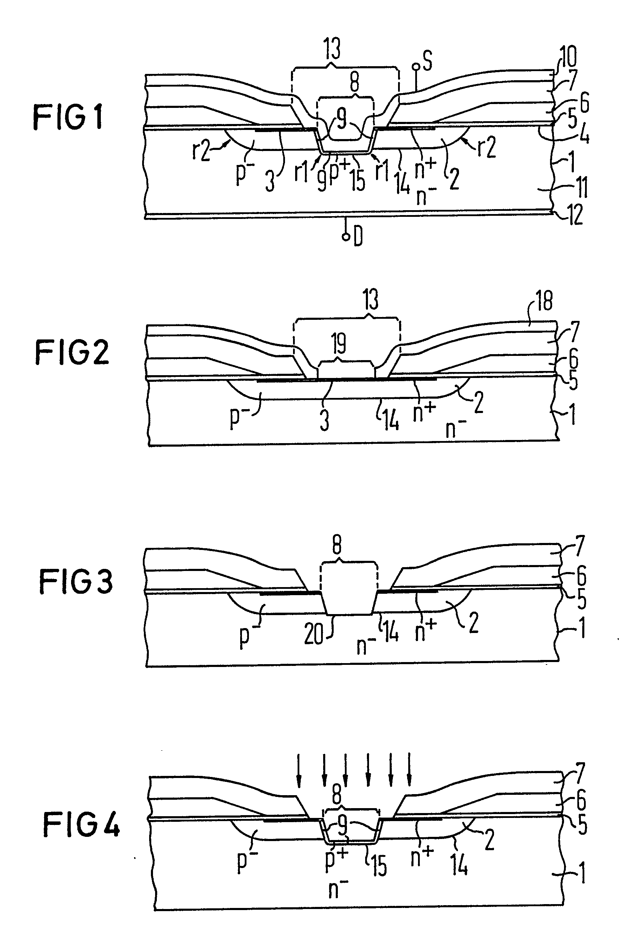

Der Halbleiterkörper des Leistungs-MOSFET nach FIG 1 ist mit 1 bezeichnet. Er besteht z. B. aus $n^-$-dotiertem Silizium. In der Halbleiterkörper 1 ist eine Gatezone planar eingebettet, deren schwach dotierter Teil mit 2 bezeichnet ist. In den Teil 2 ist eine $n^+$-dotierte Sourcezone 3 planar eingebettet. Die Drainzone wird vom $n^-$-dotierten Teil des Halbleiterkörpers 1 gebildet und ist mit 11 bezeichnet. Die sourceseitige Oberfläche 4 des Halbleiterkörpers 1 ist mit einer Schicht eines Gateoxids 5 bedeckt. Auf dem Gateoxid 5 ist eine Gateelektrode 6 angeordnet, die z. B. aus dotiertem, polykristallinem Silizium besteht. Sie überdeckt den schwach dotierten Teil 2 der Gatezone dort, wo er an die Oberfläche 4 tritt. Das Gateoxid und die Gateelektrode ist mit einem Zwischenoxid 7 bedeckt. Im Zwischenoxid 7 und im Gateoxid 5 ist eine Öffnung 13 vorgesehen. Im schwach dotierten Teil 2 der Gatezone ist ein Kontaktloch 8 angebracht, an dessen Boden und in dessen Wand eine stark p-dotierte Zone liegt. Diese bildet den stark dotierten Teil 9 der Gatezone. Die Teile 2 und 9 sind elektrisch miteinander verbunden.

Der stark dotierte Teil 9 der Gatezone bildet mit der Drainzone 11 einen pn-Übergang 15, der schwach dotierte Teil 2 einen pn-Übergang 14. Der pn-Übergang 15 hat einen größeren Abstand von der Oberfläche 4 als der pn-Übergang 14. Der Teil 9 hat senkrecht zur Oberfläche 4 ein Profil mit einem ersten Krümmungsradius r1. Der Teil 2 hat senkrecht zur Oberfläche 4 ein Profil, das unter der Gateelektrode einen Krümmungsradius r2 aufweist. Der Krümmungsradius rl ist kleiner der Krümmungsradius r2. Er kann z. B. 5 bis 10 mal kleiner sein.

Der Halbleiterkörper 1 ist auf der Sourceseite mit einer Sourceelektrode 10 bedeckt. Diese kontaktiert die Sourcezone 3 und die Teile 2 und 9 der Gatezone. Die drainseitige Oberfläche ist mit einer Drainelektrode 12 bedeckt.

Wird der Leistungs-MOSFET in Sperrichtung beansprucht, so wächst die Feldstärke im Inneren des Halbleiterkörpers an. Dabei wird bei Überschreiten einer vorgegebenen Spannung die Durchbruchsfeldstärke zuerst im stark dotierten Teil 9 an denjenigen Stellen erreicht, die den Radius r1 haben. An dieser Stelle bricht der pn-Übergang 15 durch und der Durchbruchsstrom fließt direkt in die Sourceelektrode 10 ab. Ein lateral unter der Sourcezone 3 zur Sourceelektrode 10 fließender Anteil tritt hierbei nicht auf, so daß der parasitäre Bipolartransistor nicht einschalten kann.

Im folgenden wird die Herstellung des Leistungs-MOSFET nach FIG 1 summarisch dargestellt, da die einzelnen Prozeßschritte an sich bekannt sind und von jedem Halbleiterfachmann bei Kenntnis der anhand von FIG 1 beschriebenen Struktur durchgeführt werden können.

Der Halbleiterkörper 1 nach FIG 2 wird zunächst mit einer Schicht Gateoxid 5 bedeckt. Dann wird ganzflächlg polykristallines Silizium abgeschieden und dotiert. Das polykristalline Silizium wird dann strukturiert und mit schrägen Flanken versehen. Es wird als Gateelektrode 6 verwendet. Das polykristalline Silizium dient als Maske für die nachfolgende Bor-Implantation.

Anschließend wird das Bor in die Oberfläche des Halbleiterkörpers vertikal und lateral eingetrieben. Dadurch wird der schwach dotierte Teil 2 der Gatezone gebildet. Darauf wird durch die gleiche Maske Arsen implantiert, das die Sourcezone 3 bildet. Sodann wird auf dem Gateoxid und dem polykristallinen Silizium ein Zwischenoxid 7 abgeschieden. Im Bereich der Sourcezone erhalten die Schichten 5 und 7 eine Öffnung 13. Darauf wird eine Fotolackschicht 18 gelegt. Diese wird derart strukturiert, daß im Bereich der Sourcezone eine Öffnung 19 erzeugt wird. Diese wird im allgemeinen kleiner als die Öffnung 13 sein.

Durch die Öffnung 19 der Fotolackschicht 18 wird nun ein Kontaktloch 8 geätzt (FIG 3). Die Ätzung wird so lange fortgesetzt, bis Oder Boden 20 des Kontaktloches auf der Höhe des pn-Übergangs 14 oder wenig darunter liegt. Das Kontaktloch kann sich in den Halbleiterkörper hinein verjüngenden Querschnitt haben. Nach Atzen des Kontaktloches wird eine zweite Implantation, z. B. ebenfalls mit Borionen vorgenommen. Die Dosis kann hier zwischen $7 \times 10^{13}$ und $5 \times 10^{14}/cm^2$ liegen bei einer Implantationsenergie von z. B. 30 keV. Durch die zweite Borimplantation wird der stark dotierte Teil 9 der Gatezone am Boden 20 des Kontaktloches 8 erzeugt. Hat das Kontaktloch sich verjüngenden Querschnitt, wird das Bor auch in seine Wand implantiert. Der stark dotierte Teil 9 hat dann, wie in FIG 4 dargestellt, die Form eines Napfes, dessen Boden mit dem Krümmungsradius r1 in seine Wand übergeht. Die Implantationsdosis ist wesentlich niedriger als die der Arsenimplantation. Die Sourcezone 3 bleibt daher im wesentlichen unverändert. Die implantierte Schicht wird nicht eingetrieben und ist daher wesentlich dünner als der Teil 2 der Gatezone. Da die Implantation des Teils 9 zum Teil in und durch den Teil 2 hindurch erfolgt, sind beide Teile auch elektrisch miteinander verbunden.

## Ansprüche

1. Leistungs-MOSFET mit einem Halbleiterkörper mit je mindestens einer Drainzone, einer Sourcezone, einer Sourceelektrode, einer Gateelektrode und einer Gatezone, mit den Merkmalen:
Die Gatezone hat einen stark dotierten Teil, der durch ein in der Sourcezone (3) vorgesehenes Kontaktloch (8) mit der Sourceelektrode (10) in Kontakt steht, und einen mit dem stark dotierten Teil (9) zusammenhängenden schwach dotierten Teil (2), der bis unter die Gateelektrode (6) reicht, **dadurch gekennzeichnet,** daß das Kontaktloch (8) durch den schwach dotierten Teil (2) der Gatezone geht, daß der stark dotierte Teil der Gatezone (9) mindestens am Boden (20) des Kontaktloches in die Drainzone (11) eingebettet ist derart, daß der pn-Übergang (15) zwischen dem stark dotierten Teil (9) der Gatezone und der Drainzone (11) senkrecht zur Oberfläche (4) des Halbleiterkörpers (1) ein Profil mit einem ersten Krümmungsradius (r1) zeigt, daß der pn-Übergang (14) zwischen schwach dotiertem Teil und der Drainzone (11) unter der Gatelektrode (6) senkrecht zur genannten Oberfläche ein Profil mit einem zweiten Krümmungsradius (r2) zeigt, und daß der erste Krümmungsradius kleiner als der zweite ist.

2. Leistungs-MOSFET nach Anspruch 1, daß der erste Krümmungsradius (r1) 5 bis 10 mal kleiner als der zweite Krümmungsradius (r2) ist.

3. Leistungs-MOSFET nach Anspruch 1, **dadurch gekennzeichnet,** daß das Kontaktloch (8) so tief wie der schwach dotierte Teil (2) ist, daß sich sein Querschnitt von der sourceseitigen Oberfläche (4) des Halbleiterkörpers (1) ausgehend verjüngt, und daß der stark dotierte Teil (9) der Gatezone in die Wand und den Boden (20) des Kontaktlochs (8) eingebettet ist.

4. Leistungs-MOSFET nach Anspruch 3, **dadurch gekennzeichnet,** daß der stark dotierte Teil (9) durch Ionenimplantation erzeugt ist.

5. Leistungs-MOSFET nach Anspruch 1, **dadurch gekennzeichnet,** daß der pn-Übergang zwischen stark dotiertem Teil und Drainzone weiter von der Oberfläche (4) des Halbleiterkörpers entfernt ist als der zwischen schwach dotiertem Teil und Drainzone liegenden pn-Ubergang (14).

FIG 1

FIG 2

FIG 3

FIG 4